(19) Europäisches Patentamt / European Patent Office / Office européen des brevets

(11) **EP 3 272 914 A1**

(12) **EUROPEAN PATENT APPLICATION**
published in accordance with Art. 153(4) EPC

(43) Date of publication:
**24.01.2018 Bulletin 2018/04**

(51) Int Cl.:
*C30B 29/12* (2006.01)     *G02B 1/02* (2006.01)

(21) Application number: **16764721.3**

(86) International application number:
**PCT/JP2016/056640**

(22) Date of filing: **03.03.2016**

(87) International publication number:
**WO 2016/147891 (22.09.2016 Gazette 2016/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **18.03.2015 JP 2015054837**

(71) Applicant: **Tokuyama Corporation
Shunan-shi, Yamaguchi 745-8648 (JP)**

(72) Inventors:
• **ISHIZU, Sumito**
  **Shunan-shi**
  **Yamaguchi 745-8648 (JP)**
• **FUKUDA, Kentaro**
  **Shunan-shi**
  **Yamaguchi 745-8648 (JP)**
• **MATSUO, Kentaro**
  **Shunan-shi**
  **Yamaguchi 745-8648 (JP)**

(74) Representative: **Viering, Jentschura & Partner mbB
Patent- und Rechtsanwälte
Am Brauhaus 8
01099 Dresden (DE)**

(54) **LANTHANUM FLUORIDE SINGLE CRYSTAL, AND OPTICAL COMPONENT**

(57)     A lanthanum fluoride single crystal wherein an alkaline earth metal is added to the lanthanum fluoride single crystal, and internal transmittance of light at 9.3 $\mu$m in wavelength is no less than 85 %/mm. The lanthanum fluoride single crystal and an optical component which have high transparency in an infrared region, and can be preferably used for phase plates for lasers, lenses and optical window materials for laser beam machines, gas detectors, flame detectors, infrared cameras, and so on, etc. are provided.

Fig. 1

**Description**

Technical Field

The present invention relates to a lanthanum fluoride single crystal that can be preferably used for phase plates for lasers, lenses and optical window materials for laser beam machines, gas detectors, flame detectors, infrared cameras, and so on, etc.

Background Art

An infrared window material is a material involved in advanced technologies. In recent years, window materials transmitting infrared rays of longer wavelengths have been developed.

Specifically, an infrared laser such as a carbon dioxide laser is used for processing automotive components, steel, and so on because of its characteristic of low attenuation in the atmosphere. In a carbon dioxide laser used in laser beam machines in the present situation, difference between p polarization and s polarization exerts influence upon cutting.

Reflectors that reflect infrared rays are used for controlling a degree of polarization of laser beams. However, there are some problems with a method of using reflectors that laser beam machines are upsized, optical axes are difficult to be adjusted, beam diameters are unstable, and so on. Thus, alternative methods and materials are demanded.

Citation List

Patent Literature

Patent Literature 1: JP H9-315894A
Patent Literature 2: Japanese National Publication of International Patent Application No. 2005-509583
Patent Literature 3: JP2008-202977A

Summary of Invention

Technical Problem

A lanthanum fluoride single crystal is a trigonal crystal, and can be used as optical components such as phase plates for lasers, and optical window materials (Patent Literatures 1 to 3). However, there is a problem that the transparency of a lanthanum fluoride single crystal is easy to decrease due to clouding upon manufacturing, and a clouding lanthanum fluoride single crystal cannot stand the use as the above described optical components such as phase plates for lasers, and optical window materials. In addition, the materials of Patent Literatures 1 to 3 are assumed to be specifically used for transmitting light in an ultraviolet region, for example, light from an excimer laser. There is no consideration given in Patent Literatures 1 to 3 to transparency of light in an infrared region.

An object of the present invention is to provide a lanthanum fluoride single crystal and an optical component which have high transparency in an infrared region, and can be preferably used for phase plates for lasers, lenses and optical window materials for laser beam machines, gas detectors, flame detectors, infrared cameras, and so on, etc.

Solution to Problem

As a result of various studies by the inventors of the present invention on a lanthanum fluoride single crystal having high transparency in an infrared region without clouding, they found that an alkaline earth metal is added to a lanthanum fluoride single crystal, to obtain a lanthanum fluoride single crystal having high transparency in an infrared region, and such a lanthanum fluoride single crystal can be preferably used as optical components. Thus, they completed the present invention.

That is, a first aspect of the present invention is a lanthanum fluoride single crystal wherein an alkaline earth metal is added to the lanthanum fluoride single crystal, and internal transmittance of light at 9.3 $\mu$m in wavelength is no less than 85 %/mm.

In the present invention, "internal transmittance" means light transmittance of the lanthanum fluoride single crystal which excludes surface reflection losses occurred in the surfaces in the incidence and emission sides of the lanthanum fluoride single crystal when light is transmitted through the lanthanum fluoride single crystal, which is represented by a value per 1 mm in light path length. The internal transmittance ($\tau_1$) per 1 mm in light path length can be obtained by measuring transmittance including surface reflection losses of a pair of lanthanum fluoride single crystals each having a different thickness, and assigning the measured values to the following formula (1):

$$\log(\tau_1) = \{\log(T_2) - \log(T_1)\}/(d_2 - d_1) \qquad (1)$$

(In the formula, $d_1$ and $d_2$ represent thickness of the lanthanum fluoride single crystals by mm, and $d_2 > d_1$. $T_1$ and $T_2$ represent transmittance including surface reflection losses of the lanthanum fluoride single crystals of $d_1$ and $d_2$ in thickness, respectively.)

A second aspect of the present invention is an optical component comprising the lanthanum fluoride single crystal according to the first aspect of the present invention.

An antireflection film may be provided for a surface of the optical component according to the second aspect of the present invention.

The optical component according to the second aspect of the present invention may be preferably used for transmitting an infrared laser.

Advantageous Effects of Invention

According to the lanthanum fluoride single crystal including an alkaline earth metal of the present invention, a crystal having high infrared transparency without clouding can be obtained. Such a lanthanum fluoride single crystal can be preferably used as optical components of phase plates for lasers, laser beam machines, gas detectors, flame detectors, infrared cameras, optical window materials, and so on.

Brief Description of Drawings

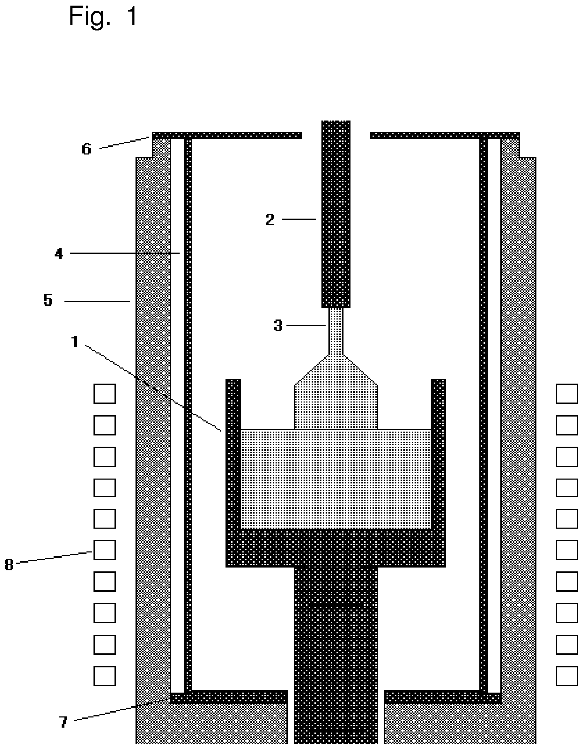

Fig. 1 shows an example of a device for producing the lanthanum fluoride single crystal of the present invention.

Description of Embodiments

A first aspect of the present invention is a lanthanum fluoride single crystal wherein an alkaline earth metal is added to the lanthanum fluoride single crystal, and internal transmittance of light at 9.3 $\mu$m in wavelength is no less than 85 %/mm.

Magnesium, calcium, strontium, barium, or the like can be unlimitedly used as the alkaline earth metal in the present invention. Strontium or barium is preferably used as the alkaline earth metal because their difference from lanthanum, which is a host crystal, in ionic radius is small. Using barium as the alkaline earth metal makes the difference from lanthanum, which is a host crystal, in ionic radius smallest, which is further preferable.

In the present invention, preferably 0.1 to 30 mol%, more preferably 1 to 20 mol%, and further preferably 3 to 10 mol% of the alkaline earth metal is added when the total thereof and lanthanum is 100 mol%. If the alkaline earth metal is added too little, its effect of suppressing clouding upon growth is not obtained. If approximately 30 to 50 mol% of the alkaline earth metal, which is a great amount, is added, a eutectic composition of lanthanum fluoride and barium fluoride forms. That is, a crystal is not a lanthanum fluoride single crystal. The whole of a crystal is white if the crystal is a eutectic composition, which makes its light transparency remarkably low. If approximately more than 50 mol% of the alkaline earth metal, which is a much greater amount, is added, a solid solution having a barium fluoride type crystal structure forms. This solid solution is isotropic, which is not appropriate to the use as phase plates for lasers.

A known device can be unlimitedly used for measuring transmittance in the present invention. Desirably, measurement can be taken with a device using gas that does not have absorbency in an infrared region, such as Ar and nitrogen, because this measurement is transmittance measurement in a long wavelength region.

Internal light transmittance of the lanthanum fluoride single crystal of the present invention at 9.3 $\mu$m in wavelength is no less than 85 %/mm, preferably no less than 90 %/mm, and especially preferably no less than 94 %/mm. A carbon dioxide laser has emission wavelengths at 9.3 $\mu$m and 10.6 $\mu$m. The crystal of the present invention, which has high transmittance at 9.3$\mu$m, is useful as phase plates for such a laser.

The lanthanum fluoride single crystal is a colorless transparent crystal, and belongs to trigonal system crystals. The lanthanum fluoride single crystal has excellent chemical stability, and no deterioration of their characteristics is found in an ordinary use for a short time. Their mechanical strength and processability are excellent as well. This lanthanum fluoride single crystal can be processed to have a desired shape, to be used.

A second aspect of the present invention is an optical component comprising the lanthanum fluoride single crystal according to the first aspect of the present invention.

The lanthanum fluoride single crystal according to the first aspect of the present invention can be unlimitedly used as various optical components. Specific examples of the optical component according to the second embodiment of the present invention include phase plates for lasers, lenses and optical window materials for laser beam machines, gas detectors, flame detectors, infrared cameras, and so on. Specifically, utilizing its excellent light transmittance at 9.3 $\mu$m in wavelength, the lanthanum fluoride single crystal can be preferably used as the optical component that is used for transmitting an infrared laser. For example, the lanthanum fluoride single crystal can be preferably used as phase plates for an infrared laser, and optical window materials that transmit an infrared laser.

A known infrared laser such as a semiconductor laser, a YAG laser, a $YVO_4$ laser, and a carbon dioxide laser can be unlimitedly used as an infrared laser. Among them, a carbon dioxide laser is an efficient laser having the emission wavelength centering on 9.3 $\mu$m. A carbon dioxide laser is preferable for the use of the lanthanum fluoride single crystal of the present invention.

An antireflection film may be provided for a surface of the optical component of the present invention. Here, examples of a material that is preferably used for the antireflection film include magnesium fluoride, barium fluoride, aluminum fluoride, yttrium fluoride, lanthanum fluoride, ytterbium fluoride, zirconium fluoride, hafnium fluoride, aluminum oxide, yttrium oxide, silicon dioxide, tantalum oxide, zinc sulfide, germanium and fluorocarbon polymers. Preferably, films made from any of the above materials are combined to form a multilayered film, and this multilayered film is used as the antireflection film. A method for forming the antireflection film on the surface of the lanthanum fluoride single crystal is not restricted. The antireflection film can be formed according to a known method such as vacuum deposition, a sputtering method, and CVD. Providing the antireflection film for the surface makes it possible to reduce a surface reflection loss, and to improve an effective transmittance of the optical component of the present invention.

A known crystal growing method can be unlimitedly applied to a method for growing the lanthanum fluoride single crystal of the present invention to which the alkaline earth metal is added.

Specifically, the lanthanum fluoride single crystal can be produced by: mixing a raw material of lanthanum fluoride with a raw material of alkaline earth metal fluoride in a desired proportion, to melt them; after that, solidifying the melt to a single crystal.

The following are specific examples of a melt-solidification method: a Bridgman method of gradually descending and cooling a melt of raw materials for producing a crystal in a crucible along with the crucible, to grow a crystal in the crucible; a Czochralski method of bringing a seed crystal that consists of a crystal to be obtained into contact with the interface of a melt of raw materials in a crucible, and then gradually pulling up the seed crystal from a heating area of the crucible and cooling the seed crystal, to grow the crystal on the bottom of the seed crystal; and a micro melt pulling down method of exuding a melt through a hole provided for the bottom of a crucible, and pulling down the exuded melt, to grow a crystal.

Among them, a Czochralski method can be preferably used in the present invention because a larger crystal can be grown compared with a micro melt pulling down method, and a crystal can be grown while influence of distortion of the crystal is more suppressed compared with a Bridgman method.

Hereinafter, a method for producing the lanthanum fluoride single crystal of the present invention will be described with reference to an example of the case of a Czochralski method.

A Czochralski method is a producing method of filling a crucible 1 with raw materials, and pulling up a crystal by a seed 3 that is attached to a seed pulling up shaft 2, using a device shown in Fig. 1. Materials used for a heater 4, a heat insulating material 5, a top board 6, and a support 7 are usually graphite, glass graphite, silicon carbide-deposited graphite, etc. Other materials can be used as well without any problem.

First, the crucible 1 is filled with a predetermined amount of raw materials. A shape of the crucible is not restricted. The lanthanum fluoride single crystal of the present invention can be grown in both a single crucible and a double crucible. Purity of the raw materials is not restricted. However, metal fluorides each having purity of 99.99 vol.% or more are preferably used.

Next, the crucible 1 filled with the above described metal fluorides, the heater 4, the heat insulating material 5, the top board 6, and the support 7 are set as shown in Fig. 1. The inside of a furnace is evacuated using an evacuator. At the same time, preferably, heating is performed using a high frequency coil 8 until temperature in the crucible reaches 350 to 1000 K. This is performed for removing moisture adhered to the furnace, carbon members, and metal fluorides. Preferably, evacuation is performed until the ultimate pressure is no more than $1.0 \times 10^{-3}$ Pa.

Preferably, a solid scavenger or a gas scavenger is used for avoiding influence of oxygen and moisture that cannot be removed even by the evacuating operation. A known solid scavenger such as zinc fluoride and lead fluoride can be unlimitedly used as the solid scavenger. Tetrafluoromethane, carbonyl fluoride, or the like can be used as the gas scavenger. The gas scavenger is preferably used for avoiding the quality of the crystal from deteriorating due to residues of a scavenger. When the solid scavenger is used, the solid scavenger is preferably placed in the furnace before evacuation. When the gas scavenger is used, the gas scavenger is introduced into the furnace individually or with inert gas such as argon of high purity mixed therewith after evacuation. To activate the scavenger, heating is preferably performed using the high frequency coil 8 until the temperature in the crucible reaches 400 K to 1800 K. In this step, oxygen and moisture contained in the metal fluorides can be removed. Further, oxygen and moisture that remain in the device for heating the metal fluorides can be removed.

Inert gas such as argon of high purity, or the gas scavenger such as carbonyl fluoride and tetrafluoromethane can be solely used, or their mixture at any mixing ratio can be used as an atmosphere in the furnace when the crystal is grown.

The lanthanum fluoride single crystal, which is to be obtained, can be obtained by continuous pulling-up at a fixed pulling-up velocity. This pulling-up velocity is not restricted. The range within 0.5 to 10 mm/hr is preferable for this velocity.

The obtained lanthanum fluoride single crystal has excellent processability, and is easy to be processed to have a desired shape, to be used. Upon processing, a known cutter such as a blade saw and a wire saw, or grinder can be used without any limitation.

The lanthanum fluoride single crystal of the present invention is appropriate for manufacturing optical components of all shapes and all orientations. Specifically, when processing is performed along a c surface, the processing can be performed while formation of cracks is suppressed, which is effective for reducing manufacturing costs, and effective for manufacturing optical window materials and lenses.

The obtained lanthanum fluoride single crystal can be processed to have a desired shape, to be used for any uses such as phase plates for lasers, gas detection, flame detection, infrared cameras, and optical window materials. When used as the optical component, the lanthanum fluoride single crystal is preferably ground according to a known method until the surface roughness is approximately no more than 10.0 nm, more preferably no more than approximately 1 nm in RMS for reducing influence of surface scattering.

When the lanthanum fluoride single crystal is used as a phase plate for a laser, preferably, processing is performed so that the c axis is orthogonal to incident light in order to utilize effect of double refraction, which trigonal system crystals have, to the utmost.

Examples

Hereinafter, examples of the present invention will be described specifically. The present invention is not restricted to these examples. All the combinations of the features described in the examples are not necessarily essential to the solution of the present invention.

Example 1

(Preparation for Growth)

Using the crystal producing device shown in Fig. 1, a lanthanum fluoride single crystal to which an alkaline earth metal was added was grown. As raw materials, barium fluoride and lanthanum fluoride each having purity of 99.99 vol.% were used. The crucible 1, the seed pulling up shaft 2, the heater 4, the heat insulating material 5, the top board 6, and the support 7 that were made by carbon of high purity were used.

First, 94 g of barium fluoride and 2000 g of lanthanum fluoride were individually weighed and well mixed together, and then the crucible 1 was filled therewith. The crucible 1 that was filled with the raw materials, the seed pulling up shaft 2, the heater 4, the heat insulating material 5, the top board 6, and the support 7 were installed as shown in Fig. 1.

(Heating and Drying Process inside Device)

Next, the inside of the furnace was evacuated until the pressure thereof reached $5.0 \times 10^{-4}$ Pa, using an evacuator composed of an oil-sealed rotary pump and an oil diffusion pump. At the same time, heating was performed using the high frequency coil 8 so that the temperature inside the crucible 1 when evacuated was 570 K.

(Step of Heating Metal Fluorides with Tetrafluoromethane)

A gas mixture of 95 vol.% of argon and 5 vol.% of tetrafluoromethane was introduced into the furnace, and the power of the high frequency coil 8 was adjusted so that the heating temperature was 1270 K using the high frequency coil 8. The pressure in the furnace after the gas mixture displacement was atmospheric pressure. Heating was continued for 2 hours under this situation.

(Evacuation of Tetrafluoromethane and Introduction of Atmospheric Gas for Growing Crystal)

Next, evacuation was carried out while heating by the high frequency coil 8 was continued, and further, an argon gas was introduced into the furnace, to carry out gas displacement. The pressure in the furnace after the argon gas displacement was atmospheric pressure.

(Step of Growing Crystal)

Using the high frequency coil 8, the raw materials were heated to the melting point of lanthanum fluoride, to be melt. While the power of the high frequency was adjusted, to change the temperature of the melt of the raw materials, the seed 3 was lowered, to be brought into contact with the melt. While the power of the high frequency was adjusted, the seed 3 was started to be pulled up and crystallization was started. The seed 3 was continuously pulled up for 24 hours at 3 mm/hr in velocity, and finally, a cylindrical crystal of 55 mm in diameter and 72 mm in length was obtained. The obtained crystal was subjected to a SEM/EDS analysis, and it was confirmed that barium of 5.08 mol% was contained in this crystal.

(Evaluation of Transmittance Characteristics of Optical Components)

The obtained crystal was cut with a blade saw having a diamond cutting wheel into approximately 15 mm in length. Side faces of the cut crystals were ground to process them to have a shape of 15 mm in length, 2 mm in width, and 1 mm in thickness ($d_1$), and a shape of 15 mm in length, 2 mm in width and 5 mm in thickness ($d_2$). Two faces of 15 mm in length and 2 mm in width on each shape were set as infrared light transmission surfaces. The infrared light transmission surfaces were subjected to optical polishing, and the resultants were used as samples for spectral measurement. Light transmittance at 9.3 $\mu$m in wavelength was measured under a nitrogen atmosphere using a Fourier transform infrared spectrometer (manufactured by JEOL Ltd., Type: JIR-7000), to measure transmittance $T_1$ and $T_2$ including surface reflection losses for each sample of $d_1$ and $d_2$ in thickness. Internal transmittance ($\tau_1$) per 1 mm in light path length was calculated by assigning the thickness $d_1$ and $d_2$ and the transmittance $T_1$ and $T_2$ into the above described formula (1) (Table 1).

Example 2

A crystal was grown, samples for spectral measurement were produced, and transmittance at 9.3 $\mu$m was measured in the same way as the example 1 except that 18 g of barium fluoride and 1982 g of lanthanum fluoride were individually weighed in the step of growth preparation (Table 1). The obtained crystal was subjected to a SEM/EDS analysis, and it was confirmed that barium of 2.23 mol% was contained in this crystal.

Example 3

A crystal was grown, samples for spectral measurement were produced, and transmittance at 9.3 $\mu$m was measured in the same way as the example 1 except that 181 g of barium fluoride and 1819 g of lanthanum fluoride were individually weighed in the step of growth preparation (Table 1). The obtained crystal was subjected to a SEM/EDS analysis, and it was confirmed that barium of 8.54 mol% was contained in this crystal.

Example 4

A crystal was grown, samples for spectral measurement were produced, and transmittance at 9.3 $\mu$m was measured in the same way as the example 1 except that 273 g of barium fluoride and 1727 g of lanthanum fluoride were individually weighed in the step of growth preparation (Table 1). The obtained crystal was subjected to a SEM/EDS analysis, and it was confirmed that barium of 11.65 mol% was contained in this crystal.

Example 5

A crystal was grown, samples for spectral measurement were produced, and transmittance at 9.3 $\mu$m was measured in the same way as the example 1 except that 366 g of barium fluoride and 1634 g of lanthanum fluoride were individually weighed in the step of growth preparation (Table 1). The obtained crystal was subjected to a SEM/EDS analysis, and it was confirmed that barium of 16.22 mol% was contained in this crystal.

Comparative Example 1

A crystal was grown, samples for spectral measurement were produced, and transmittance at 9.3 μm was measured in the same way as the example 1 except that only 2000 g of lanthanum fluoride was weighed in the step of growth preparation (Table 1).

When the examples 1 to 5 were compared with the comparative example 1, it was found that while influence of scattering made the transmittance low in the comparative example 1 where barium fluoride was not contained, the transmittance was improved in the examples 1 to 5 where barium fluoride was added.

[Table 1]

|  | Concentration of Barium in Crystal (mol%) | Internal Transmittance (%/mm) |
|---|---|---|
| Example 1 | 5.08 | 95.3 |
| Example 2 | 2.23 | 95.1 |
| Example 3 | 8.54 | 95.3 |
| Example 4 | 11.65 | 95.4 |
| Example 5 | 16.22 | 95.3 |
| Comp. Ex. 1 | - | 73.2 |

Reference Signs List

1: crucible

2: seed pulling up shaft

3: seed

4: heater

5: heat insulating material

6: top board

7: support

8: high frequency coil

**Claims**

1. A lanthanum fluoride single crystal wherein
an alkaline earth metal is added to the lanthanum fluoride single crystal, and internal transmittance of light at 9.3 μm in wavelength is no less than 85 %/mm.

2. An optical component comprising the lanthanum fluoride single crystal according to claim 1.

3. The optical component according to claim 2, wherein an antireflection film is provided for a surface of the optical component.

4. The optical component according to claim 2 or 3, wherein the optical component is used for transmitting an infrared laser.

Fig. 1

**INTERNATIONAL SEARCH REPORT**

| International application No. |
| --- |
| PCT/JP2016/056640 |

A.  CLASSIFICATION OF SUBJECT MATTER
*C30B29/12*(2006.01)i, *G02B1/02*(2006.01)i

According to International Patent Classification (IPC) or to both national classification and IPC

B.  FIELDS SEARCHED

Minimum documentation searched (classification system followed by classification symbols)
C30B29/12, G02B1/02

Documentation searched other than minimum documentation to the extent that such documents are included in the fields searched
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
JSTPlus/JST7580(JDreamIII), CA/REGISTRY(STN)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | ROOS A., Crystal growth of solid solutions $La_{1-x}Ba_xF_{3-x}$, Materials Research Bulletin, 1983, Vol.18, No.4, p.405-409, ISSN 0025-5408, particularly, Abstract, Results and Discussion | 1<br>2-4 |
| Y | WO 2012/046323 A1  (Kogakugiken Corp.), 12 April 2012 (12.04.2012), paragraphs [0013] to [0015], [0021], [0027] to [0028], [0060]; fig. 1 (Family: none) | 2-4 |
| Y | JP 9-315894 A  (Canon Inc.), 09 December 1997 (09.12.1997), claims 1, 9, 23; paragraph [0046] & US 2002/0020338 A1 paragraphs [0016], [0025], [0033], [0060] | 3 |

| ☒  Further documents are listed in the continuation of Box C. | ☐  See patent family annex. |
| --- | --- |

| * Special categories of cited documents: | "T"  later document published after the international filing date or priority date and not in conflict with the application but cited to understand the principle or theory underlying the invention |
| --- | --- |
| "A"  document defining the general state of the art which is not considered    to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search<br>31 March 2016 (31.03.16) | Date of mailing of the international search report<br>12 April 2016 (12.04.16) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2016/056640

C (Continuation). DOCUMENTS CONSIDERED TO BE RELEVANT

| Category* | Citation of document, with indication, where appropriate, of the relevant passages | Relevant to claim No. |
|---|---|---|
| X | JP 10-26602 A (Mitsubishi Electric Corp.), 27 January 1998 (27.01.1998), claim 6; paragraph [0017] & US 5876578 A claim 6; column 4, lines 59 to 61 & EP 818677 A1 & DE 69720330 D & DE 69720330 T & CN 1174993 A | 1 |
| X | SOROKIN N. I.,et al., Superionic conductivity of the heterovalent solid solutions $R_{1-x}M_xF_{3-x}$ (R=REE,M=Ca,Ba) with tysonite-type structure, Physics of the Solid State, 1999, Vol.41, No.4, p.573-575, ISSN 1063-7834S, particularly, Experimental procedure, Table.1 | 1 |
| A | GLUSHKOVA T. M., et al., Refractometry of single crystals of solid solutions of $La_{1-x}Sr_xF_{3-x}$ ($0 \leqq x \leqq 0.15$) with the tisonite structure., Journal of Optical Technology, 1997, Vol.64, No.3, p.195-197, ISSN 1070-9762 | 1-3 |
| A | US 2007/0199816 A1 (SUN Zhisheng), 30 August 2007 (30.08.2007), claims 1 to 3, 10; paragraphs [0002], [0017], [0024] & WO 2007/100490 A2 | 1-3 |
| A | JP 2008-202977 A (Tokuyama Corp.), 04 September 2008 (04.09.2008), claims 2, 3; example 1 & US 2010/0001191 A1 claims 2, 3; example 1 & WO 2008/099971 A1 & EP 2112529 A1 & KR 10-2009-0119824 A | 1-3 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9315894 A
- JP 2005509583 A
- JP 2008202977 A